# EUROPEAN PATENT SPECIFICATION

(11) **EP 2 831 929 B1**
(45) Date of publication and mention of the grant of the patent: **05.05.2021**
(21) Application number: 13717181.5
(22) Date of filing: 13.03.2013
(51) Int. Cl.: H01L 31/18, H01L 31/0687, H01L 31/0304, C30B 33/06, C30B 29/06, H01L 21/18, H01L 21/20, H01L 21/62

(54) **MANUFACTURE OF MULTIJUNCTION SOLAR CELL DEVICES**
HERSTELLUNG VON SOLARZELLENVORRICHTUNGEN MIT MEHREREN ÜBERGÄNGEN
FABRICATION DE DISPOSITIFS À CELLULES SOLAIRES MULTIJONCTIONS

(30) Priority: 28.03.2012 EP 12290107
(43) Date of publication of application: 04.02.2015
(73) Proprietor: Soitec, 38190 Bernin (FR); Fraunhofer-Gesellschaft zur Förderung der angewandten Forschung e.V., 80686 München (DE)
(72) Inventor: GHYSELEN, Bruno, F-38170 Seyssinet (FR); ARENA, Chantal, Mesa, Arizona 82505 (US); DIMROTH, Frank, 79115 Freiburg (DE); BETT, Andreas W., 79114 Freiburg (DE)
(74) Representative: Grünecker Patent- und Rechtsanwälte PartG mbB
(86) International application number: PCT/EP2013/055144
(87) International publication number: WO 2013/143854

(56) References cited:
- EP-A1- 2 760 055
- US-A1- 2004 166 681
- US-A1- 2006 112 986
- US-A1- 2006 185 582
- US-A1- 2009 038 678
- MELISSA J GRIGGS ET AL: "Design Approaches and Materials Processes for Ultrahigh Efficiency Lattice Mismatched Multi-Junction Solar Cells", CONFERENCE RECORD OF THE 2006 IEEE 4TH WORLD CONFERENCE ON PHOTOVOLTAIC ENERGY CONVERSION (IEEE CAT. NO.06CH37747),, 7 May 2006 (2006-05-07), - 12 May 2006 (2006-05-12), pages 857-860, XP031041755, ISBN: 978-1-4244-0016-4
- BOISVERT J ET AL: "Development of space solar cells at Spectrolab", PHOTOVOLTAIC SPECIALISTS CONFERENCE (PVSC), 2011 37TH IEEE, IEEE, 19 June 2011 (2011-06-19), pages 1528-1531, XP032167994, DOI: 10.1109/PVSC.2011.6186250 ISBN: 978-1-4244-9966-3
- TAKAMOTO T ET AL: "Future development of InGaP/(In)GaAs based multijunction solar cells", CONFERENCE RECORD OF THE THIRTY-FIRST IEEE PHOTOVOLTAIC SPECIALIST CONFERENCE (IEEE CAT. NO. 05CH37608) IEEE PISCATAWAY, NJ, USA,, 3 January 2005 (2005-01-03), pages 519-524, XP010822762, DOI: 10.1109/PVSC.2005.1488184 ISBN: 978-0-7803-8707-2
- SHARPS P R ET AL: "Wafer bonding for use in mechanically stacked multi-bandgap cells", CONFERENCE RECORD OF THE 26TH IEEE PHOTOVOLTAIC SPECIALISTS CONFERENCE - 1997. PVSC '97. ANAHEIM, CA, SEPT. 29 - OCT. 3, 1997; [IEEE PHOTOVOLTAIC SPECIALISTS CONFERENCE], NEW YORK, NY : IEEE, US, 29 September 1997 (1997-09-29), pages 895-898, XP010268023, DOI: 10.1109/PVSC.1997.654231 ISBN: 978-0-7803-3767-1

## Description

### Field of Invention

The present invention relates to the manufacture of multijunction solar cell substrates, in particular, to the manufacture of multijunction solar cell substrates comprising layer transfer processes and the manufacture of solar cell devices for terrestrial and space-related applications.

### Background of the invention

Photovoltaic or solar cells are designed for converting the solar radiation to electrical current. In concentrator solar photovoltaic applications the incoming sun light is optically concentrated before it is directed to solar cells. For example, the incoming sun light is received by a primary mirror that reflects the received radiation toward a secondary mirror that, in turn, reflects the radiation toward a solar cell, which converts the concentrated radiation to electrical current by the generation of electron-hole pairs in III-V semiconductor or single crystal silicon, for example. Alternatively, the sunlight could be concentrated onto solar cells by using transmittive optics like Fresnel lenses.

M.J. Griggs et al., in a paper entitled "Design Approaches and Materials Processes for Ultrahigh Efficiency Lattice Mismatched Multi-Junction Solar Cells", Conference Record of the 2006 IEEE 4th World Conference on Photovoltaic Energy Conversion, 1 May 2006, pages 857 to 860, describe a multi-junction solar cell made by integration of two 2- junction cells grown on templates by means of direct bonding wherein the bonded templates are formed by layer transfer and wafer bonding utilizing co-implantation of H+ or He2+ ions. A stack of a 4-junction cell comprising a GaAs cap, GaInP/GaAs/InGaAsP/InGaAs and an Si substrate is also disclosed. US 2006/185582 A1 discloses methods for the formation of solar cells utilizing wafer bonding and layer transfer, particularly, for 4-junction or 5-junction designs and 5-junction cells comprising a substrate, for example, an InP substrate and InGaAs/InGaAsP/InP/GaAsP/InGaP or InGaAs/InGaAsP/InP/InGaP/AlInP.

J. Boisvert et al., in a paper entitled "Development of space solar cells at Spectrolab", Photovoltaic Specialists Conference 2001, 37th IEEE, 19 June 2011, pages 1528 to 1531, teach an inverted metamorphic 3-junction solar cell. The cell comprises a Ge or GaAs substrate and GalnP/GalnAs/AlGalnAs or GaInP/GaInAs.

T. Takamoto et al., in a paper entitled "Future development of InGaP/(In)GaAs based multijunction solar cells", Conference Record of the thirty-first IEEE Photovoltaic Specialists Conference, 3 January 2005, pages 519 to 524, describe InGaP/(In)GaAs based multijunction solar cells including InGaP/GaAs/Ge cells, InGaP/InGaAs/Ge and a 4-junction AlGaInP/GaAs/GaInNAs/Ge cell.

P.R. Sharps et al., in a paper entitled "Wafer bonding for use in mechanically stacked multi-bandgap cells", Conference Record of the 26th Photovoltaic Specialists Conference, September 29 - October 3, 1997, pages 895 to 898,teach wafer bonding in the context of multi-bandgap cells wherein wafer bonding parameters of 350 to 600 °C for time periods of 1 to 90 minutes. Particularly, a four junction solar cell comprising an InP substrate and GalnAs/GalnAsP/GaAs/GalnP and a GaAs cap is disclosed.

US 2004/166681 A1 discloses multijunction solar cells employing metal layers for bonding. Furthermore, a 4-junction solar cell comprising a substrate made of GaAs, Ge, InP or Si and InGaP/InGaAs/InGaAs/InGaAs or SiGe is disclosed.

EP 2 760 055 A1 (this document falls under Art. 54(3) EPC) and US 2009/038678 A1 teach methods of forming a multijunction solar cell device comprising growing sub-cell layers over a sacrificial substrate in order to obtain a solar cell structure, growing other sub-cell layers on another sacrificial substrate in order to obtain another solar cell structure, bonding the solar cell structure and the other solar cell structure to each other and removing the sacrificial substrates. US 2006/112986 A1 discloses wafer bonding in the context of the formation of multijunction solar cells and teaches growth of sub-cell layers of a substrate, bonding of the resulting structures and removal of a sacrificial substrate by laser lift-off of a zipper layer and bonding to a final substrate.

Since different semiconductor material composition show optimal absorption for different wavelengths of the incoming solar light, multijunction solar cells have been proposed that comprise, for example, three cells showing optimal absorption in different wavelength ranges. A triple cell structure may comprise a GalnP top cell layer with a gap value of 1.8 eV, a GaAs intermediate cell layer with a gap value of 1.4 eV and a Ge bottom cell layer with a gap value of 0.7 eV, for instance. In principle, III-V or group IV semiconductors can be used as active cells layers of multijunction solar cell devices manufactured by layer transfer/bonding. Multijunction solar cells are usually manufactured by monolithic epitaxial growth. The monolithic growth process requires, in general, that any formed layers be substantially lattice matched to previously formed layers or the underlying substrate. However, the epitaxial growth of the solar cell layers on growth substrates still provides a demanding problem in view of lattice mismatches. For example, it is not suitable to epitaxially grow an InP solar cell layer on a Ge substrate, since the crystalline and optical characteristics of the InP solar cell layer would be heavily deteriorated due to crystal mismatch. In addition, in conventionally used layer transfer processes intermediate substrates are lost after the transfer of epitaxially grown layers.

Thus, despite the recent engineering progress there is still a need for an improved manufacturing process for multijunction solar cell devices wherein solar cell layers with a low defect rate are achieved and an intermediate substrate can be recycled.

### Description of the Invention

The present invention addresses the above-mentioned need and, accordingly, provides according to claim 1 a method for manufacturing a multijunction solar cell device, comprising the steps of
providing a first engineered substrate comprising a first base layer and a first seed layer and a first zipper layer that facilitates detachment of the first engineered substrate after wafer bonding in a later processing step and that is arranged between the first base layer and the first seed layer;
providing a second engineered substrate comprising a second base layer and a second seed layer and a second zipper layer that facilitates detachment of the second engineered substrate after wafer bonding in a later processing step and that is arranged between the second base layer and the second seed layer;
forming at least one first solar cell subcell layer on the first engineered substrate to obtain a first wafer structure;
forming at least one second solar cell subcell layer on the second seed layer of the second engineered substrate to obtain a second wafer structure;
and further comprising the following steps subsequently performed in the given order
bonding the first wafer structure to the second wafer structure by bonding the at least one first solar cell subcell layer to the at least one second solar cell subcell layer;
detaching the second engineered substrate; patterning the at least one first solar cell subcell layer and the at least one second solar cell subcell layer;
bonding a third, temporary, substrate to the patterned at least one second solar cell subcell layer;
detaching the first engineered substrate; and
bonding a fourth substrate to the at least one patterned first solar cell subcell layer.

The term "engineered substrate" comprises a substrate that is different from a mere pure bulk substrate but rather includes a layer or interface that is formed in the substrate in order to facilitate its removal from the structure resulting of the bonding of the first and second wafer structures. In particular, the "engineered substrate" may comprise a zipper layer between a seed layer and a base substrate. In particular, the engineered substrate may comprise a base substrate that is detached from the seed layer in the step of removal of the engineered substrate.

Detachment by means of the zipper layer allows for recycling the detached substrate.

In the document, the expression "detachment of the engineered substrate" should be interpreted as the detachment of the base substrate. This detachment step may be followed by the removal of the possible residue of the zipper layer (if any), and of the removal of the seed layer from the remaining structure.

The zipper layer may be a weakened layer formed, e.g., by an appropriate treatment, for instance, a hydrogen and/or helium implantation in a substrate, that delimits an upper seed layer and a lower base substrate.

The zipper layer may be formed by a buried porous layer by anodic etching at a surface of the base substrate. Then epitaxial growth of the seed layer can be performed on top of the porous layer.

The zipper layer may be provided in form of an absorbing layer for laser lift-off, chemical lift off or mechanical splitting in an intermediate strained layer during an epitaxy sequence: SiGe in Si matrix, in particular, an intermediate strained layer of SiGe at 20% in a Si substrate. In this alternative, the zipper layer may be formed by the seed layer itself, for instance the seed layer can be selectively and chemically etched away to detach the engineered substrate.

The zipper layer may also be formed of a SiN absorbing layer for laser lift-off inserted between a seed layer and a transparent base substrate, as known for example from WO2010/015878.

Another possibility for an engineered substrate reads as follows: A removable (presenting a low bonding energy of less than 1.5 J/m², and preferentially less than 1J/m²) bonding interface is formed between facing surfaces of a seed layer and a base support. In that possibility, the zipper layer is formed by the removable bonding interface. A first solar cell layer may be grown by epitaxy on the seed layer while preserving the removable character of the bonding interface, with the engineered substrate being heated to an epitaxial growth temperature. The low energy bonding is obtained by performing a treatment for augmenting the roughness of the facing surface of one of the seed layer or the substrate in particular carried out by chemical attack or etching, by effecting a treatment for decreasing hydrophilicity of the facing surface of one of the seed layer or the substrate (or the bonding layer in SiO₂ or Si₃N₄ on each of them). Moreover, a different material for the bonding layer can be chosen such that weak intrinsic mutual chemical affinity of the interface materials is achieved. The detachment of the base substrate may be performed by application of a thermal treatment or mechanical stresses applied from a jet of fluid or a blade, for example. This kind of detachment is disclosed for instance in WO03/063214.

As already mentioned, the engineered substrate includes a seed layer formed at the top of the zipper layer or removable bonding interface. The seed layer is transferred from the seed substrate to a base substrate by layer transfer from wafer to wafer, for example, by the Smart Cut™ process. The seed layer may contain or not an epitaxial layer that has been formed originally by epitaxy on the seed substrate. Alternatively, the seed layer has been transferred or detached from a bulk seed substrate. In a preferred embodiment of the present invention, the seed layer is not used as a solar cell layer but rather a first solar cell layer is grown on the seed layer.

The seed layer is not necessarily used as part of a solar cell layer because its band gap may not be adapted for an optimal efficiency in the sequence of cell layers that will eventually form the multijunction solar cell. Therefore, in an embodiment of the present invention the seed layer is only used for the growth of the first solar cell layer thereby resulting in a multijunction solar cell device comprising a first solar cell layer (as a bottom cell) satisfying both crystal and electrical characteristics. In fact, according to the above example one might remove the seed layer later in the process, e.g., by chemical treatment such as etching.

In the above-described examples the solar cell layers can be grown with high crystal and electrical quality. For example, a dislocation density of less than 10⁶ / cm² can be achieved.

The detachment at the zipper layer may be performed by laser lift-off: A laser beam is radiated to the engineered substrate, for example, comprising a sapphire substrate, and provokes the decomposition of the material in the zipper layer thereby allowing for detachment at the zipper layer.

According to the invention, it is the first engineered base substrate that provides mechanical stability to the stacked solar cell layers during the patterning process (like mesa and cap layer etching of the stacked solar cell layers, and/or anti-reflective coating realisation and/or front side metallization) and during the bonding to the temporary substrate. The structure including the temporary substrate after detachment (and residues removal) of the first base substrate is bonded to the final base substrate and after removal of the temporary substrate the already finished or semi-finished (at least with respect to the processing of the solar cell layers) multijunction solar cell is achieved. The temporary substrate may be in glass wafer, silicon and the bonding may be performed by glue, wax etc such that to be easily reversible by solvent or heat treatment or other methods well known by the one skilled in the art. The detachment of the temporary substrate is obtained by dissolution of the glue with a solvent or heat treatment that does not damage the subcell layers.

In all of the above-described embodiments the final bonding to the final base substrate can be performed by means of an electrically conductive (metallic, or with conductor oxides, transparent conductor oxide TCO, silicide, etc) bonding layer formed between the first solar cell layer and the final base substrate. The electrically conductive bonding can also be performed by direct bonding, i.e without any intermediate bonding layers and by direct contacting the surfaces of the first solar cell and the final base substrate. An electrically conductive bonding particularly helps also to provide for thermal conductivity to the final base substrate that may function as a heat sink or may be connected to a heat sink and preferably is itself thermally and electrically conductive. The conductive bonding may be obtained by forming an eutectic contact such as Au/Sn or by a thermo-compression technique such as Au/Au thermo-compression.

The step of bonding the first wafer structure to the second wafer structure can include a high-temperature treatment performed at a temperature of about 400 °C to about 600 °C, and more preferably between 450°C and 550°C thereby allowing a reliable bond between the semiconductor materials of the solar cell layers.

The advantage of the process is that the bonding of the solar cell layer is performed while the final base substrate is not present in the structure yet. Thus, risk of metallic contaminations is avoided during bonding, and thermal treatment such that high temperature may be used. Moreover, the expansion of the final base substrate that would be different from the expansion of the first and second substrate at such a temperature due to different coefficient of thermal expansion (CTE) would damage the structure, in particular it would weaken the bonding interface between the semiconductor materials.

A final base substrate made of tungsten or molybdenum or doped semiconductors like Ge, GaAs or InP may be particularly suitable for receiving the stack of solar cell layers provided on a second substrate made of GaAs or GaAsOS (see below) for instance. In particular the difference in CTE of the final base substrate to the CTE of the second substrate should be less than 30% in order to avoid problems related to the bonding to the final substrate.

In case of direct bonding of the first wafer structure to the second wafer structure, which forms the preferred embodiment according to the invention, the polishing of the surface of the solar cell layers to be bonded may be performed in order to smooth the surface, better than to 0.5 nm RMS over a field of 5x5 micrometers for example to obtain a enhanced bonding strength between the solar cell layers and improved efficiency and reliability of the subsequent solar cell.

Alternatively, an electrically conductive, optically transparent material can be used as a bonding layer and facilitates the adhesion of the two structures.

Particularly, the second engineered substrate may comprise a sapphire substrate and the second seed layer may comprise or consist of InP, Ge or GaAs. In that instance, the removal of the second engineered substrate can be performed by detachment of the sapphire substrate, for example, from the seed layer.

The first engineered substrate, on the other hand, may comprise a sapphire substrate and the first seed layer may comprise or consists of InP, GaSb, InAs or GaAs in all of the above examples for the inventive method.

According to a particular variant, in the above-described examples, the at least one first solar cell layer comprises two layers, a first and a second layer, that has been grown by epitaxy on the first layer, and the at least one second solar cell layer also comprises two layers, namely a fourth and a third layer that has been grown by epitaxy on the fourth layer so that to provide inverted grown layers. In other terms, in the second solar cell, the layer having the smaller band gap is grown on top of the layer having the higher band gap. According to a particular example, the first layer (bottom cell) comprises or consists of GaInAs and/or the second layer comprises or consists of GaInAsP and/or the fourth layer (top cell in the finished multijunction solar cell device) comprises or consists of GalnP and/or the third layer comprises or consists of GaAs. Thus, a four-cell multijunction solar cell device is achieved wherein the material of each cell is optimized for a particular wavelength of the incoming solar light.

By the term "layer" it is understood a functional photovoltaic layer. Such functional layer may comprise several individual layers having different crystal nature or composition, and includes the necessary junctions, tunnel diode, barrier layers, etc.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates an example for a method for the manufacturing of a multijunction solar cell comprising two wafer bonding steps not being part of the present invention.
Figure 2 illustrates an example for the inventive method for the manufacturing of a multijunction solar cell comprising three wafer bonding steps.
Figure 3 illustrates another example for a method for the manufacturing of a multijunction solar cell not being part of the present invention where no inversion of the formed solar cell layers is included.

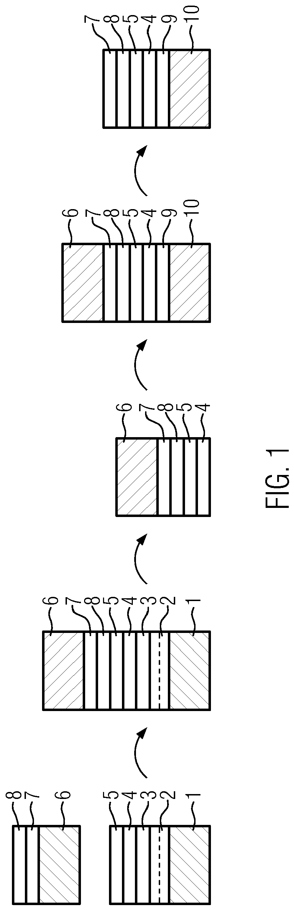

An example for a method for the manufacturing of a multijunction solar cell comprising four solar cell layers not being part of the present invention is shown in Figure 1. A first engineered base substrate comprising a zipper layer 2 for later detachment of the first base substrate 1 is provided. The term "engineered" generally refers to a substrate that is treated in a way to introduce some layer or interface within the substrate that facilitates detachment of the substrate after wafer bonding in a later processing step. For example, the first base substrate 1 is a sapphire substrate. Sapphire may preferably be chosen in view of its coefficient of thermal expansion which is of importance for the temperature change (up & down) during epitaxy and for the further processing, in particular, bonding step (see below). Moreover, sapphire is transparent to laser light and can, thus, allow for laser lift-off in a later processing step (see below). A seed layer 3, for example, an InP, Ge, GaSb, InAs or GaAs seed layer is formed on the first base substrate 1. For example, the seed layer may be grown on a seed substrate and then be transferred to the base substrate. Alternatively, the seed layer is taken off from a bulk seed substrate. The zipper layer 2 may comprise a layer of SiN interposed between the base substrate and the seed layer. In a variant, the zipper layer is the seed layer itself, InP for example. Since the seed layer 3 will not function as a solar cell layer but only as a seed for the epitaxial growth of a first solar cell layer 4, this seed layer can be used as a sacrificial layer to facilitate detachment of the base substrate, for example being the media where decomposition will occur or as another example enabling separation by lateral selective etching of the seed layer.

The thickness of the InP seed layer may be in the range of 50 nm to 1 µm. On the first solar cell layer 4 a second solar cell layer 5 is grown.

Furthermore, it is provided a second substrate 6 whereupon a fourth solar cell layer 7 and a third solar cell layer 8 are epitaxially grown. The second substrate 6 may be a bulk GaAs or Ge substrate. Alternatively, the second substrate 6 may be an engineered GaAsOS or GeOS ("OS" indicating "on sapphire") substrate comprising a zipper layer similar to the one provided for the first base substrate 1 to allow the recycling of a portion of the substrates 1 and/or 6 that allowed the epitaxy of the subcell layers. In case of engineered substrate, the portion that can be recycled is the base substrate. It is particularly advantageous when the base substrate is expensive, such as sapphire. The GaAs and Ge layer bonded via the zipper layer to the base substrate is a seed layer that is substantially lattice-matched with material of the third and the fourth solar cells 7, 8 so that epitaxy of the solar cells leads to sufficient crystalline quality, (dislocation density less than 10⁶ / cm²) for subsequent operation in the multijunction solar cell devices.

The four solar cell layers 4, 5, 7, 8 show absorption maxima for incident solar light for different wavelengths. It should be noted that the first solar cell layer 4 becomes the bottom cell and the fourth solar cell layer 7 becomes the top cell in the finished multijunction solar cell device (see description below). According to the present example all of the four monocrystaline solar cell layers 4, 5, 7, 8 are formed by epitaxial growth. In principle, the material of the solar cell layers can be selected from III-V semiconductors of the group consisting of InGaAs, GaAs, AIGaAs, InGaP, InP, GaSb, AlGaAsSb and InGaAsP. For example, the first solar cell layer 4 may be comprised of InGaAs, the second solar cell layer 5 may be comprised of InGaAsP, the third solar cell layer 7 may be comprised of GaAs, and the fourth solar cell layer 8 may be comprised of GalnP or InGaP. Each solar cell layer may include functional layers such as barrier for minority carrier, tunnel diode, etc. Appropriate tunnel junction layers may also be provided between particular ones of the solar cell layers by deposition or growth on a respective solar cell layer.

As it is illustrated in Figure 1, the resulting wafer structures comprising the first base substrate 1 and the first two solar cell layers 4 and 5 and the second substrate 6 and second two solar cell layers 7 and 8, respectively, are bonded together. The bonding is preferably performed by direct bonding of the structures, or in other words molecular adhesion of the two faces in contact, without any bonding layers. Molecular adhesion is performed preferably under partial vacuum. Contacting and bonding can be performed at relatively high temperatures of about 400 °C to 600 °C and more preferably between 450 °C and 550 °C. Preferably, the contacting step is performed at room temperature followed by an annealing step reaching max temperature between 400° and 600°C, although it is not excluded to perform the contacting step at a higher temperature. This bonding step is crucial for the quality of the resulting multijunction solar cell and it is favourable to perform high-temperature bonding in order to achieve a bonding interface (between solar cell layers 5 and 8) without significant defects. Furthermore, multiple wafer structures comprising the first base substrate 1 may be bonded adjacently to a larger wafer structure comprising the second substrate 6. For example, GaAs can be provided at a size of 6" and InP at a size of 2 or 3".

Subsequently, the first base substrate 1 is detached from the seed layer 3 by means of the zipper layer 2, for example, the first engineered substrate is cleaved at the zipper layer 2 allowing the detachment of first base substrate 1 from the seed layer 3. For instance, the zipper layer 2 may be provided in form of a weakened layer formed by the implantation of ionic species, for example, hydrogen or helium ions. In this case, the first substrate 1 can be provided as a bulk InP substrate, the implantation through the main top surface of the bulk substrate forms the weakened layer 2 that creates the seed layer 3 and the first base substrate 1 respectively in the top portion and the bottom portion of the bulk substrate. Then detachment of the first base substrate 1 can be mediated by the application of mechanical forces to delaminate at the weakened layer formed by hydrogen or helium ions.

Moreover, residue of the base substrate and/or bonding layer and the seed layer 3 may be removed by etching and/or polishing, for example, in particular if the seed layer 3 shows poor electrical and/or thermal properties and could not be used in the subsequent device. The thus obtained structure is then bonded to a final base substrate 10. This bonding process may be performed by direct conductive bonding the first solar cell layer 4 to the final base substrate 10 or by means of a metallic bonding layer 9 that is formed on the exposed surface of the first solar cell layer 4 or the final base substrate 10 before the bonding process. It is also possible to form a metallic bonding layer on the exposed surface of the first solar cell layer 4 and the final base substrate 10, respectively.

It is noted that the detached first base substrate 1 can be recycled to form a new engineered substrate for the re-usage as a growth substrate for epitaxial layers.

In the next step illustrated in Figure 1 the second substrate 6 is removed, e.g., by grinding and/or thinning or etching. If the second substrate 6 is provided in form of an engineered substrate as mentioned above, detachment is mediated by the zipper layer of the engineered substrate. The resulting structure is then subject to some finish processing comprising the formation of a plurality of mesas comprising etched solar cell layers. The formation of the mesas can be achieved by lithographic processing after the formation of an appropriately patterned photoresist and optionally formed anti-reflective coating. Note that the first solar cell layer 4 grown on seed layer 3 is the bottom cell in the resulting multijunction solar cell and that solar cell layers 7 and 8 have to be formed in reversed order with respect to the final orientation in the resulting multijunction solar cell.

It is noted that the final base substrate 10 may function as a thermally and electrically conductive substrate. Particularly, the final base substrate 10 may be made of Cu or Al, in particular, made of an aluminium sheet stiff enough to provide support of the stacked solar cell layers. Other envisaged candidates for the final base substrate 10 comprise Si, such as doped silicon, Mo and W.

A final base substrate made of tungsten or molybdenum or doped semiconductors like Ge, GaAs or InP may be particularly suitable for receiving the stack of solar cell layers provided on a second substrate made of GaAs or GaAsOS (see below) for instance. In particular the difference in CTE of the final base substrate to the CTE of the second substrate should be less than 30% in order to avoid problems related to the bonding to the final substrate.

It is furthermore noted that according to a variant of the example illustrated in Figure 1 a bulk substrate, in particular, an InP bulk substrate may be provided instead of the first engineered substrate.

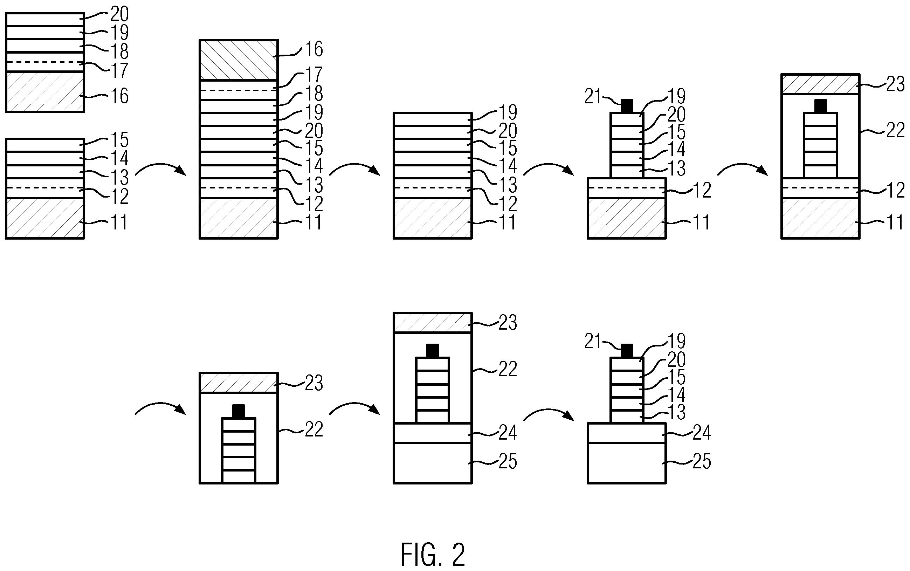

Figure 2 illustrates an example for the inventive method for the manufacturing of a multijunction solar cell comprising three wafer bonding steps. It is provided a first engineered substrate in form of an InPOS (InP layer bonded on sapphire substrate) substrate comprising a first zipper layer 12, a first base substrate 11 in sapphire and an InP seed layer 13. On the InP seed layer 13 a first solar cell layer 14 and second solar cell layer 15 are epitaxially grown. It is further provided a second engineered substrate in form of a GaAsOS (GaAs on sapphire) substrate comprising a second zipper layer 17, a sapphire second base substrate 16 and a GaAs seed layer 18. On the GaAs seed layer 18 a fourth solar cell layer 19 and a third solar cell layer 20 are epitaxially grown. Wafer bonding at the second and third solar cell layers 15 and 20 is performed as in the example shown in Figure 1. As both base substrates 11 and 16 are in sapphire, the base substrates have the same CTE such that the same material expansion occurs in the bottom and in the top of the bonded structure and bonding temperature may be as high as 600°C without decreasing the strength of the bonding. However, in the next step of this example the second substrate 16 is detached. Detachment is facilitated by the second zipper layer 17. Thereafter, the GaAs seed layer 18 is removed (e.g., by polishing, thinning and/or etching).

The advantage of both first and second base substrates 11, 16 in sapphire is that both are perfectly matched in CTE with the whole stack of solar cell layers which makes it possible to apply bonding temperatures as high as 600°C without degrading the solar cell. A similar reasoning applies to materials as for instance Ge, GaAs or InP which may be used as first and second base substrates 11, 16. The used first base substrate 11 may not be conductive, as for instance sapphire, which makes the bonding to a final base substrate which is conductive necessary. Preferentially, the materials of the first and second base substrate 11, 16 may be different, but the difference in their CTE should be less than 30% in order to allow high bonding temperatures. The use of Si for the first or second base substrate however is not suitable due to the difference in CTE between the seed layer used for growth of the solar cell layers and the base substrate with regard to the high temperatures used for epitaxial growth of the solar cell layers.

Different from the example shown in Figure 1, finish processing including the formation of a mesa from the stack of solar cell layers is performed on the InPOS first engineered substrate rather than the final base substrate which may be advantageous in terms of the efficiency of the workflow and easiness of the processing. However, if it is preferred, the finish processing may be performed after transfer to a final base substrate. A contact 21 may be formed atop of the solar cell layer 19 (top cell). The resulting structure has to be transferred to a final base substrate. For this, it is bonded by means of glue material 22, for example, to another substrate 23 that may be provided in form of glass and provided a mechanical support of the solar cell layer structure.

Subsequently, the first base substrate 11 can be detached. Detachment is facilitated by the first zipper layer 12. A final base substrate 25 is then bonded to the surface exposed by detachment by means of the zipper layer. The bonding of the final base substrate 25 can be achieved by means of a metallic bonding layer 24, for example. Subsequently, both the glue material 22 and the other substrate 23 are removed. It is noted that whereas in Figure 2 the glue material 22 and the other substrate 23 are illustrated as separate elements, in principle, they can be formed uniformly.

Whereas the second substrate is provided in form of an engineered substrate, it is also possible to provide it in form of a GaAs bulk substrate whereupon the third and fourth solar cell layers are epitaxially grown. In this case, the GaAs second substrate is removed by grinding or etching. The final base substrate 25 as well as the solar cell layers may be made of the same materials as described with reference to Figure 1.

The engineered substrates of the above-described examples can be fabricated by means of layer transfer of the respective seed layers to the base substrates. For example, an InP epitaxial layer or as another example a strained or relaxed InGaAs layer may be the surface layer of an initial bulk InP seed substrate which is subsequently transferred to a sapphire substrate by the well-known Smart Cut™ process. The remainder of initial bulk seed substrate can be recycled after the transfer. The base substrates can also be recycled after the respective detachment steps. For forming an InP seed layer, it is preferable to apply the well known Smart Cut™ process onto a bulk InP seed substrate. Applying the same process onto an epitaxial stack composed of InP may be chosen however offering more options regarding for instance the choice of doping levels, crystalline quality and exact process to manufacture the seed layer. As an alternative to the Smart Cut™ technology, any layer transfer process can be used, such as the bond and thin back technique.

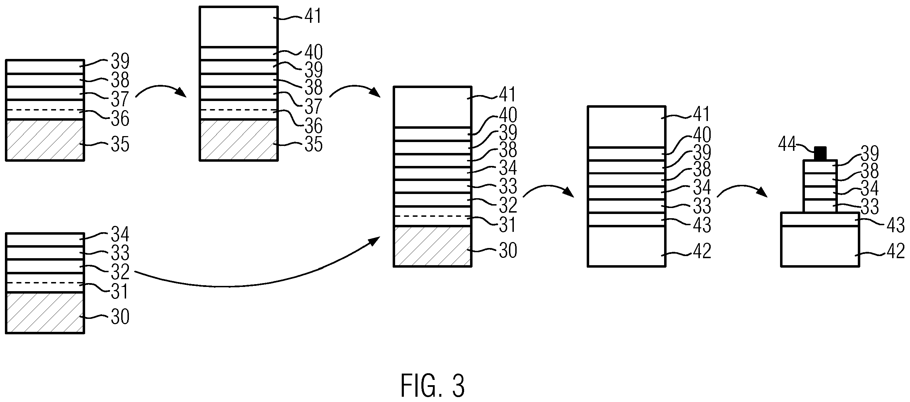

Figure 3 shows another example for manufacturing a multijunction solar cell not being part of the present invention. Two engineered substrates are provided: A first sapphire base substrate 30 including a zipper layer 31 and a second sapphire base substrate 35 including another zipper layer 36. On the first base substrate 30 an InP layer 32 is formed and on the second base substrate 35 a GaAs layer 37 is formed. Note, that according to an alternative a bulk GaAs substrate may be provided instead of the second engineered substrate.

A first and a second solar cell layer 33 and 34 are formed on the InP layer and a third and a fourth solar cell layer 38 and 39 are formed on the GaAs layer 37. Materials for the solar cell layers can be chosen as described in the above examples. Then, for lift-off of the second substrate and removal of the GaAs layer 37 a handling substrate 41 is attached by means of an adhesive layer 40 to the fourth solar cell layer 39. The handling substrate 41 can be a glass substrate and the adhesive layer can be a glue layer. After lift-off of the second base substrate 35 and removal of the GaAs layer 37 bonding at the second and third solar cell layers 34 and 38 is performed resulting in the structure shown on the right-hand-side of the upper row in Figure 3.

After lift-off of the first base substrate 30 and removal of the InP layer 32 the solar cell layer stack is attached to the final base substrate 42 by a metallic bonding layer 43. The adhesive layer 40 and the handling substrate 41 are removed and, subsequently, the solar cell layer stack is patterned and a contact 44 is formed atop of the solar cell layer 39 (top cell). An advantage of this example can be seen in that no inversion of the third and fourth solar cell layers 38 and 39 is necessary. On the other hand, another step of attachment to a handling substrate 41 is needed and the bonding at the second and third solar cell layers 34 and 38 poses some problem due to the limited temperature at which the bonding can take place.

All previously discussed embodiments are not intended as limitations but serve as examples illustrating features and advantages of the invention. It has to be understood that some or all of the above described features can also be combined in different ways. In particular, it is possible according to the invention to form multijunction solar cells not only composed of 4 junctions (as generally disclosed in the previous embodiments) but also 2, 3, 5 or more.

## Claims

1. Method for manufacturing a multijunction solar cell device comprising the steps of providing a first engineered substrate comprising a first base layer (11) and a first seed layer (13) and a first zipper layer (12) that facilitates detachment of the first engineered substrate after wafer bonding in a later processing step and that is arranged between the first base layer (11) and the first seed layer (13);
providing a second engineered substrate comprising a second base layer (16) and a second seed layer (18) and a second zipper layer (17) that facilitates detachment of the second engineered substrate after wafer bonding in a later processing step and that is arranged between the second base layer (16) and the second seed layer (18);
forming at least one first solar cell subcell layer (14, 15) on the first engineered substrate to obtain a first wafer structure;
forming at least one second solar cell subcell layer (19, 20) on the second seed layer (18) of the second engineered substrate to obtain a second wafer structure;
and further comprising the following steps subsequently performed in the given order bonding the first wafer structure to the second wafer structure by bonding the at least one first solar cell subcell layer to the at least one second solar cell subcell layer;
detaching the second engineered substrate; patterning the at least one first solar cell subcell layer (14, 15) and the at least one second solar cell subcell layer (19, 20);
bonding a third, temporary, substrate (23) to the patterned at least one second solar cell subcell layer (19, 20);
detaching the first engineered substrate; and
bonding a fourth substrate (25) to the at least one patterned first solar cell subcell layer (14, 15).

2. The method according to claim 1, wherein
the zipper layer (12) is formed by an electromagnetic absorbing layer between the seed layer (13) and the base layer (11) of the first engineered substrate and detachment of the first engineered substrate is performed by laser lift-off; or
the zipper layer (12) is a weakened layer and detachment of the first engineered substrate is performed by application of thermal or mechanical strain; or
the zipper layer (12) is a porous layer;
the zipper layer (12) represents a low bonding interface.

3. The method according to claim 1, wherein the second engineered substrate comprises a sapphire substrate and the second seed layer (18) comprises or consists of InP, GaAs or Ge.

4. The method according one of the preceding claims, wherein the first engineered substrate comprises a sapphire substrate and the first seed layer comprises or consists of InP, InAs, GaSb or GaAs.

5. The method according to one of the preceding claims, wherein the at least one first solar cell subcell layer (14, 15) comprises a first (14) and a second layer (15) and/or the at least one second solar cell subcell layer (19, 20) comprises a third (19) and a fourth layer (20).

6. The method according to claim 5, wherein the first layer (14) comprises or consists of GalnAs and/or the second layer (15) comprises or consists of GaInAsP and/or the third layer (19) comprises or consists of GaAs and/or the fourth layer (20) comprises or consists of GalnP.

7. The method according to claim 5, wherein the second layer (15) and third layer (19) is formed respectively on the first (14) and fourth layer (20) or the second layer (15) and fourth layer (20) is formed respectively on the first (14) and third layer (19).

8. The method according to one of the preceding claims, wherein the step of bonding the first wafer structure to the second wafer structure is performed by direct bonding.

9. The method according to one of the preceding claims, wherein the step of bonding the first wafer structure to the second wafer structure is performed at room temperature followed by annealing treatment performed at a temperature of about 400 °C to about 600 °C, in particular, between 450 °C and 550 °C.

10. The method according to one of the preceding claims, wherein providing the first engineered substrate comprises
growing the first seed layer (13) on a seed substrate; and
transferring the first seed layer (13) to a sapphire substrate.

## Patentansprüche

1. Verfahren zum Herstellen einer Mehrfach-Solarzelle-Vorrichtung, mit den Schritten
Bereitstellen eines ersten entwickelten Substrats, das eine erste Basisschicht (11) und eine erste Saatschicht (13) und eine erste Reißschicht (12), die eine Ablösung des ersten entwickelten Substrats nach einer Waferbondierung in einem späteren Prozessschritt ermöglicht, und die zwischen der ersten Basisschicht (11) und der ersten Saatschicht (13) angeordnet ist, umfasst;
Bereitstellen eines zweiten entwickelten Substrats, das eine zweite Basisschicht (16) und eine zweite Saatschicht (18) und eine zweite Reißschicht (17), die eine Ablösung des zweiten entwickelten Substrats nach einer Waferbondierung in einem späteren Prozessschritt ermöglicht, und die zwischen der zweiten Basisschicht (16) und der zweiten Saatschicht (18) angeordnet ist, umfasst;
Ausbilden von zumindest einer ersten Solarzelle-Subzellenschicht (14, 15) auf dem ersten entwickelten Substrat, um eine erste Wafer-Struktur zu erhalten;
Ausbilden von zumindest einer zweiten Solarzelle-Subzellenschicht (19, 20) auf der zweiten Saatschicht (18) des zweiten entwickelten Substrats, um eine zweite Wafer-Struktur zu erhalten;
und weiterhin mit den folgenden in der angegebenen Reihenfolge ausgeführten Schritten
Bondieren der ersten Waferstruktur an die zweite Waferstruktur durch Bondieren der zumindest einen ersten Solarzelle-Subzellenschicht an die zumindest eine zweite Solarzelle-Subzellenschicht;
Ablösen des zweiten entwickelten Substrats;
Strukturieren der zumindest einen ersten Solarzelle-Subzellenschicht (14, 15) und der zumindest einen zweiten Solarzelle-Subzellenschicht (19, 20);
Bondieren eines dritten, temporären Substrats (23) an die strukturierte zumindest eine zweite Solarzelle-Subzellenschicht (19, 20);
Ablösen des ersten entwickelten Substrats; und
Bondieren eines vierten Substrats (25) an die strukturierte zumindest eine erste Solarzelle-Subzellenschicht (14, 15).

2. Das Verfahren gemäß Anspruch 1, wobei
die Reißschicht (12) aus einer elektromagnetisch absorbierenden Schicht zwischen der Saatschicht (13) und der Bassisschicht (11) des ersten entwickelten Substrats gebildet wird, und die Ablösung des ersten entwickelten Substrats durch Laser-Lift-Off erfolgt; oder
die Reißschicht (12) eine geschwächte Schicht ist, und die Ablösung des ersten entwickelten Substrats durch einer thermischen oder mechanischen Spannung erfolgt; oder
die Reißschicht (12) eine poröse Schicht ist;
die Reißschicht (12) eine Schwachbondierungsgrenzfläche darstellt.

3. Das Verfahren gemäß Anspruch 1, wobei das zweite entwickelte Substrat ein Saphirsubstrat umfasst und die zweite Saatschicht (18) InP, GaAs oder Ge umfasst oder daraus besteht.

4. Das Verfahren gemäß einem der vorhergehenden Ansprüche, wobei das erste entwickelte Substrat ein Saphirsubstrat umfasst und die erste Saatschicht InP, InAs, GaSb oder GaAs umfasst oder daraus besteht.

5. Das Verfahren gemäß einem der vorhergehenden Ansprüche, wobei die zumindest eine erste Solarzelle-Subzellenschicht (14, 15) eine erste (14) und eine zweite (15) Schicht umfasst und/oder die zumindest eine zweite Solarzelle-Subzellenschicht (19, 20) eine dritte (19) und eine zweite (20) Schicht umfasst.

6. Das Verfahren gemäß Anspruch 5, wobei die erste Schicht (14) GalnAs umfasst oder daraus besteht und/oder die zweite Schicht (15) GalnAsP umfasst oder daraus besteht und/oder die dritte Schicht (19) GaAs umfasst oder daraus besteht und/oder die vierte Schicht (20) GaInP umfasst oder daraus besteht.

7. Das Verfahren gemäß Anspruch 5, wobei die zweite Schicht (15) und die dritte Schicht (19) auf der ersten Schicht (14) beziehungsweise der vierten Schicht (20) ausgebildet sind oder die zweite Schicht (15) und die vierte Schicht (20) auf der ersten Schicht (14) beziehungsweise der dritten Schicht (19) ausgebildet sind.

8. Das Verfahren gemäß einem der vorhergehenden Ansprüche, wobei der Schritt des Bondierens der ersten Waferstruktur an die zweite Waferstruktur durch direktes Bondieren ausgeführt wird.

9. Das Verfahren gemäß einem der vorhergehenden Ansprüche, wobei der Schritt des Bondierens der ersten Waferstruktur an die zweite Waferstruktur bei Raumtemperatur gefolgt von einer Ausheizbehandlung ausgeführt wird, die bei einer Temperatur von etwa 400 °C bis etwa 600 °C, insbesondere zwischen 450 °C und 550 °C, ausgeführt wird.

10. Das Verfahren gemäß einem der vorhergehenden Ansprüche, wobei das Bereitstellen des ersten entwickelten Substrats umfasst
Aufwachsen der ersten Saatschicht (13) auf einem Saatsubstrat; und
Übertragen der ersten Saatschicht (13) auf ein Saphirsubstrat.

## Revendications

1. Procédé de fabrication d'un dispositif à cellules solaires multi-jonction comprenant les étapes consistant à
fournir un premier substrat conçu comprenant une première couche de base (11) et une première couche de germe (13) et une première couche zip (12) qui facilite le détachement du premier substrat conçu après une liaison de plaquette lors d'une étape de traitement ultérieure et qui est disposée entre la première couche de base (11) et la première couche de germe (13) ;
fournir un deuxième substrat conçu comprenant une deuxième couche de base (16) et une deuxième couche de germe (18) et une deuxième couche zip (17) qui facilite le détachement du deuxième substrat conçu après une liaison de plaquette lors d'une étape de traitement ultérieure et qui est disposée entre la deuxième couche de base (16) et la deuxième couche de germe (18) ;
former au moins une première couche de sous-cellule de cellule solaire (14, 15) sur le premier substrat conçu pour obtenir une première structure de plaquette ;
former au moins une deuxième couche de sous-cellule de cellule solaire (19, 20) sur la deuxième couche de germe (18) du deuxième substrat conçu pour obtenir une seconde structure de plaquette ;
et comprenant en outre les étapes suivantes effectuées ultérieurement dans l'ordre donné consistant à
lier la première structure de plaquette à la seconde structure de plaquette en liant la au moins une première couche de sous-cellule de cellule solaire à la au moins une deuxième couche de sous-cellule de cellule solaire ;
détacher le deuxième substrat conçu ;
mettre en forme la au moins une première couche de sous-cellule de cellule solaire (14, 15) et la au moins une deuxième couche de sous-cellule de cellule solaire (19, 20) ;
lier un troisième substrat, temporaire, (23) à la au moins une deuxième couche de sous-cellule de cellule solaire (19, 20) mise en forme ;
détacher le premier substrat conçu ; et
lier un quatrième substrat (25) à la au moins une première couche de sous-cellule de cellule solaire (14, 15) mise en forme.

2. Procédé selon la revendication 1, dans lequel
la couche zip (12) est formée par une couche absorbante électromagnétique entre la couche de germe (13) et la couche de base (11) du premier substrat conçu et le détachement du premier substrat conçu est effectué par décollage laser ; ou
la couche zip (12) est une couche affaiblie et le détachement du premier substrat conçu est effectué par application d'une contrainte thermique ou mécanique ; ou
la couche zip (12) est une couche poreuse ;
la couche zip (12) représente une interface de faible liaison.

3. Procédé selon la revendication 1, dans lequel le deuxième substrat conçu comprend un substrat en saphir et la deuxième couche de germe (18) comprend ou est constituée de InP, GaAs ou Ge.

4. Procédé selon l'une des revendications précédentes, dans lequel le premier substrat conçu comprend un substrat en saphir et la première couche de germe comprend ou est constituée de InP, InAs, GaSb ou GaAs.

5. Procédé selon l'une des revendications précédentes, dans lequel la au moins une première couche de sous-cellule de cellule solaire (14, 15) comprend une première (14) et une deuxième couche (15) et/ou la au moins une deuxième couche de sous-cellule de cellule solaire (19, 20) comprend une troisième (19) et une quatrième couche (20).

6. Procédé selon la revendication 5, dans lequel la première couche (14) comprend ou est constituée de GaInAs et/ou la deuxième couche (15) comprend ou est constituée de GaInAsP et/ou la troisième couche (19) comprend ou est constituée de GaAs et/ou la quatrième couche (20) comprend ou est constituée de GalnP.

7. Procédé selon la revendication 5, dans lequel la deuxième couche (15) et la troisième couche (19) sont formées respectivement sur la première (14) et la quatrième couche (20) ou la deuxième couche (15) et la quatrième couche (20) sont formées respectivement sur la première (14) et la troisième couche (19).

8. Procédé selon l'une des revendications précédentes, dans lequel l'étape de liaison de la première structure de plaquette à la seconde structure de plaquette est réalisée par liaison directe.

9. Procédé selon l'une des revendications précédentes, dans lequel l'étape de liaison de la première structure de plaquette à la seconde structure de plaquette est réalisée à température ambiante suivie d'un traitement de recuit réalisé à une température d'environ 400°C à environ 600°C, en particulier entre 450°C et 550°C.

10. Procédé selon l'une des revendications précédentes, dans lequel la fourniture du premier substrat conçu comprend
la croissance de la première couche de germe (13) sur un substrat de germe ; et
le transfert de la première couche de germe (13) sur un substrat en saphir.
